# EUROPEAN PATENT APPLICATION

(11) **EP 4 797 265 A1**
(43) Date of publication of application: **26.08.2026**
(21) Application number: 26157704.3
(22) Date of filing: 10.02.2026
(51) Int. Cl.: G11C 7/10, G11C 16/26, G11C 16/32

(54) **NONVOLATILE MEMORY DEVICE USING SEPARATE COMMAND/ADDRESS INTERFACE, METHOD OF OPERATING THE MEMORY DEVICE, AND STORAGE DEVICE INCLUDING THE MEMORY DEVICE**

(30) Priority: 21.02.2025 KR 20250023191
(71) Applicant: Samsung Electronics Co., Ltd., Suwon-si, Gyeonggi-do 16677 (KR)
(72) Inventor: KIM, Sang-Lok, 16677 Suwon-si (KR); PARK, Taehyeon, 16677 Suwon-si (KR); YOON, Chiweon, 16677 Suwon-si (KR); JO, Youngmin, 16677 Suwon-si (KR)
(74) Representative: Marks & Clerk LLP

(57) **Abstract**

A storage device includes a nonvolatile memory device including an input/output register, the nonvolatile memory device sensing data from a memory region corresponding to an address and transmitting the data that is sensed from the memory region, and a storage controller that transmits a command and the address to the nonvolatile memory device via a first bus and that transmits and receives data to and from the nonvolatile memory device via a second bus. The nonvolatile memory device, in response to a first command that is received from the storage controller, outputs a sensing status of first data and stores the first data in the input/output register.

## Description

### BACKGROUND

The present disclosure relates to semiconductor memory devices and, more particularly, to a storage device using a separate command/address interface and a method of operating the same.

Driven by technology advancements, demands for higher data input/output (I/O) speeds in flash memory devices, a type of nonvolatile memory devices, are increasing. In the related arts, interfacing methods are insufficient to satisfy the high-speed requirements.

However, even when the data I/O speed of flash memory device increases, the actual efficiency may not be improved unless the overhead associated with data input/output is reduced. For example, when the processes for data input/output take the same amount of time, the efficiency of data input/output may not be enhanced.

### SUMMARY

It is an aspect to provide a storage device with improved data input/output efficiency using a separate command/address (SCA) memory interface.

According to an aspect of one or more embodiments, there is provided a storage device comprising a nonvolatile memory device comprising an input/output register, the nonvolatile memory device configured to sense data from a memory region corresponding to an address and to transmit the data that is sensed from the memory region; and a storage controller configured to transmit a command and the address to the nonvolatile memory device via a first bus and to transmit and receive data to and from the nonvolatile memory device via a second bus. The nonvolatile memory device is configured to, in response to a first command that is received from the storage controller, output a sensing status of first data and store the first data in the input/output register.

According to another aspect of one or more embodiments, there is provided a nonvolatile memory device configured to receive a command and an address via a first bus and transmit and receive data to and from an external device that is external to the nonvolatile memory device via a second bus. The nonvolatile memory device comprises a memory cell array configured to store data; a page buffer circuit configured to sense data from the memory cell array; an input/output register electrically connected to a data input/output pin; and a control circuit configured to, in response to a first command that is received from the external device, output a sensing status of first data and store the first data in the input/output register.

According to yet another aspect of one or more embodiments, there is provided a method of operating a nonvolatile memory device, the method comprising receiving a read command via a first bus, the read command being for reading first data from an external device that is external to the nonvolatile memory device; receiving a first command via the first bus, the first command being related to the first data; in response to the first command, outputting status information of a status register via the first bus; in response to the first command, storing the first data in an input/output register based on the status information; and in response to a select chip enable signal, outputting the first data stored in the input/output register via a second bus.

At least some of the above and other features of the invention are set out in the claims.

### BRIEF DESCRIPTION OF DRAWINGS

FIG. 1 is a block diagram illustrating a storage device according to one or more embodiments.
FIG. 2 is a block diagram illustrating a configuration of a storage controller according to one or more embodiments.
FIG. 3 is a diagram illustrating a first command sequence according to one or more embodiments.
FIG. 4 is a block diagram illustrating an operation of a storage device according to one or more embodiments.
FIG. 5 is a timing diagram illustrating an example of a method of receiving a first command using a separate command/address (SCA) protocol according one or more embodiments.
FIGS. 6 and 7 are diagrams illustrating address packets received along with a first command according to one or more embodiments.
FIG. 8 is a diagram illustrating a configuration of a nonvolatile memory device of a storage device according to one or more embodiments.
FIG. 9 is a diagram illustrating a memory block having a 3D V-NAND structure, applicable to a storage device according to one or more embodiments.
FIG. 10 is a block diagram illustrating a configuration of a memory device according to one or more embodiments.
FIG. 11 is a block diagram illustrating a configuration of a memory device according to one or more embodiments.
FIG. 12A is a diagram illustrating a chip interleaving operation for reading data, performed by a memory device, according to the related art.
FIGS. 12B and 12C are diagrams each illustrating a chip interleaving operation for reading data, performed by a memory device, according to or more embodiments.
FIG. 13 is a flowchart illustrating a method of operating a memory device according to one or more embodiments.

### DETAILED DESCRIPTION

As discussed above, demands for higher data I/O speeds in flash memory devices are increasing, and related art interfacing methods, which share input/output (I/O) pins for commands, addresses, or data, are insufficient to satisfy the high-speed requirements. As a result, nonvolatile memory devices are adopting separate command/address CA pins and data DQ pins.

However, even when the data I/O speed of flash memory device increases, the actual efficiency may not be improved unless the overhead associated with data input/output is reduced. For example, when the processes for data input/output take the same amount of time, the efficiency of data input/output may not be enhanced.

Various embodiments are directed to a storage device with improved data input/output efficiency using a separate command/address (SCA) memory interface.

The following description with reference to the accompanying drawings is provided to assist in a comprehensive understanding of various embodiments of the present disclosure.

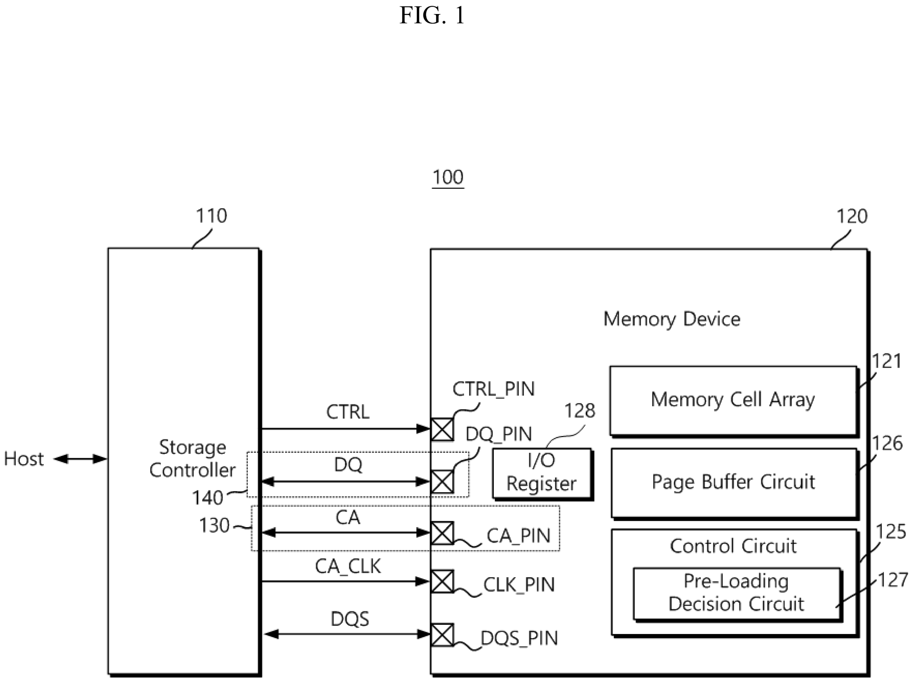

FIG. 1 is a block diagram illustrating a storage device 100 according to one or more embodiments.

Referring to FIG. 1, the storage device 100 may include a storage controller 110 and a nonvolatile memory device 120. In one or more embodiments, the nonvolatile memory device 120 may include a memory cell array 121, a control circuit 125, a page buffer circuit 126, and an input/output (I/O) register 128. In one or more embodiments, the control circuit 125 may include a pre-loading decision circuit 127.

The memory device 120 of the storage device 100 may output a status of the memory device 120 in response to a first command and may store data, sensed by the page buffer circuit 126, in the input/output register 128. The data stored in the input/output register 128 may be output from the memory device 120 based on a data strobe signal DQS.

The storage device 100 according to one or more embodiments will be described in greater detail with reference to FIG. 1.

The storage controller 110 may control the memory device 120 to perform input/output requests from a host. The host may be an external device that is external from the storage device 100. The storage controller 110 may be configured to control the memory device 120 in response to command or control from the host. The input/output requests may include write, read, and/or erase operations of user data requested by the host for the storage device 100. In the present disclosure, write data may be used interchangeably with or similarly to storing or programming data.

For example, the storage controller 110 may write data into the memory device 120 or read data stored in the memory device 120 in response to a request of the host. The storage controller 110 may provide control signals CTRL, data signals DQ, command/address signals CA, command/address clock signals CA_CLK, and data strobe signals DQS to the memory device 120 to communicate with the memory device 120. According to one or more embodiments, each signal may be transmitted unidirectionally or bidirectionally.

The storage controller 110 may transmit the command/address signal CA to the memory device 120 via a first bus 130 and may transmit/receive data signals DQ to/from the memory device 120 via a second bus 140.

The storage controller 110 may transmit various additional signals, other than the signals illustrated in FIG. 1, to the memory device 120.

The memory device 120 may receive the control signals CTRL, the data signals DQ, the command/address signals CA, the command/address clock signals CA_CLK, and the data strobe signals DQS through a control pin CTRL_PIN, a data pin DQ_PIN, a command/address pin CA_PIN, a command/address clock pin CLK_PIN, and a data strobe pin DQS_PIN, respectively. Each pin may include at least one pin. For example, two or more command/address pins CA_PIN and/or eight or more data pins DQ_PIN may be provided. The first bus, through which the command/address clock signal CA_CLK is transmitted, may be formed using the command/address pin CA_PIN. The second bus, through which the data signal DQ is transmitted/received, may be formed using the data pin DQ_PIN.

The memory device 120 may store data received from the storage controller 110 or may transmit stored data to the storage controller 110. The memory device 120 may serve as a storage medium of the storage device 100. For example, the memory device 120 may be provided as a NAND-type flash memory having high storage capacity. The memory device 120 may include a plurality of nonvolatile memory devices. For example, the memory device 120 may include a plurality of flash memory devices. The memory device 120 may include flash memory devices having a 2D structure or a 3D structure. The flash memory devices may include other types of nonvolatile memory, such as a NAND flash memory, a vertical NAND (V-NAND) flash memory, a NOR flash memory, a magnetic RAM (MRAM), a phase RAM (PRAM), a ferroelectric random access memory (FRAM), a spin transfer torque random access memory (STT-RAM), and/or a resistive RAM (RRAM).

In general, a plurality of flash memory devices may be connected to the storage controller 110 in units of channels. A plurality of flash memory devices, communicating through the same data bus, may be connected to a single channel. The memory device 120 may communicate with the storage controller 110 using a channel/way interleaving method.

Although not illustrated in FIG. 1, according to one or more embodiments, the storage device 100 may include a buffer memory device. The buffer memory device may be used as a data buffer for data exchange between the storage device 100 and the host. The buffer memory device may temporarily store write data provided from the host or data read from the memory device 120. When data present in the memory device 120 is cached in response to a read request of the host, the buffer memory device may support a cache function to directly provide the cached data to the host. The buffer memory device may be provided as synchronous DRAM to provide sufficient buffering in the storage device 100 used as a high-capacity auxiliary storage device. However, it will be apparent to those skilled in the art that the buffer memory device is not limited to the present disclosure.

The memory cell array 121 may include a plurality of memory blocks, and each of the plurality of memory blocks may include a plurality of memory cells.

The control circuit 125 may control various operations within the memory device 120. For example, the control circuit 125 may write data into or read data from the memory cells of the memory cell array 121 in response to a command received from the storage controller 110.

The page buffer circuit 126 may sense current or voltage of a selected bitline to sense data stored in a memory cell during a read operation of the memory device 120. The page buffer circuit 126 may temporarily store the data sensed from the memory cells.

When the memory device 120 outputs data, the input/output register 128 that is electrically connected to the input/output circuit may transmit data to the input/output circuit. The input/output circuit may channel-encode the data and then output the channel-encoded data through the data pin DQ_PIN. The input/output circuit may align the data signal DQ with the data strobe signal DQS and then output the aligned data signal DQ.

The control circuit 125 according to one or more embodiments may output the status of the memory device 120 in response to a first command and store data sensed by the page buffer circuit 126 in the input/output (I/O) register 128.

In one or more embodiments, the memory device 120 may sense first data from a specified address in the memory cell array 121 in response to a read command and may store the sensed first data in the page buffer circuit 126.

Then, the memory device 120 may output the status of the memory device 120 within a first time in response to the first command received from the storage controller 110. The first time may be predetermined. The first time may be a first time after the receipt of the first command. A first time period may be a period between the receipt of the first command and the first time after the receipt of the first command. For example, the memory device 120 may output a sensing status of the first data within the first time (e.g., within the first time period). The sensing status may be information that directly or indirectly indicates whether sensing of the first data from the memory cell array 121 has succeeded or failed. For instance, if the sensing of the first data has succeeded, the sensing status may comprise success information. Success information may indicate that the sensing of the first data has succeeded.

The pre-loading decision circuit 127 of the memory device 120 may store the first data in the input/output (I/O) register 128 in response to the first command, based on the success information of the sensing of the first data. For example, the pre-loading decision circuit 127 may store the first data in the input/output (I/O) register 128 based on the success information of the sensing of the first data, without receiving an additional command from the storage controller 110.

In the present disclosure, pre-loading may refer to preparing sensed data into a state ready for output within the memory device 120. For example, pre-loading may refer to transmitting sensed data to the input/output (I/O) register 128 connected to the data input/output circuit.

In one or more embodiments, the pre-loading decision circuit 127 may store the first data in the input/output (I/O) register 128 within a second time from a time point at which the success information of the sensing of the first data is obtained. The second time may be preset. For instance, the second time may be a second time after the first time. A second time period may be a period between the first time and the second time after the first time. The pre-loading decision circuit 127 may store the first data in the I/O register 128 before the end of the second time (e.g., before the end of the second time period). For example, in response to the first command, the pre-loading decision circuit 127 may store the first data in the input/output (I/O) register 128 within the sum of the first time and the second time (e.g., within the first time period and the second time period).

The memory device 120 may output the data stored in the input/output (I/O) register 128 based on the data strobe signal DQS. For example, the memory device 120 may align the data signal DQ with the data strobe signal DQS and output the aligned data signal DQ.

The memory device 120 according to one or more embodiments may output the sensing status of data in response to a single first command and may store the sensed data in the input/output (I/O) register 128 when the sensing is successful. Accordingly, after the storage controller 110 checks the sensing status of the data, the memory device 120 may output the sensed data without the storage controller 110 transmitting a command to output the sensed data again. For example, the memory device 120 may output the sensed data without receiving a readout command from the storage controller 110. As a result, overhead for data input/output may be reduced and data input/output efficiency may be improved.

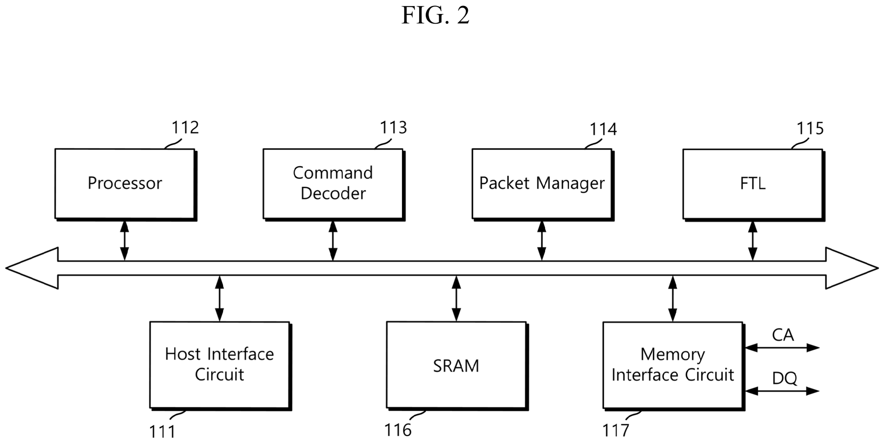

FIG. 2 is a block diagram illustrating a configuration of a storage controller 110 according to one or more embodiments. The storage controller 110 described with reference to FIG. 2 may correspond to the storage controller 110 of FIG. 1.

The storage controller 110 may include a host interface circuit 111, a processor 112, a command decoder 113, a packet manager 114, a flash translation layer (FTL) 115, an SRAM 116, and a memory interface circuit 117.

The storage controller 110 may communicate with a host through the host interface circuit 111. The host interface circuit 111 may be implemented with various interface protocols such as Advanced Technology Attachment (ATA), Serial ATA (SATA), external SATA (e-SATA), Small Computer Small Interface (SCSI), Serial Attached SCSI (SAS) Peripheral Component Interconnection (PCI), PCI express (PCIe), IEEE 1394, universal serial bus (USB), NVMe, and/or Compute eXpress Link (CXL).

The host interface circuit 111 may receive a data strobe signal DQS from the host or transmit a data strobe signal DQS to the host. In one or more embodiments, the host interface circuit 111 may generate a data strobe signal DQS that starts toggling after a delay based on a read enable signal received from the host. The delay may be predetermined.

The processor 112 may be implemented as a circuit, logic, code, or combinations thereof. The processor 112 may control the overall operation of the storage device 100 including the storage controller 110. When the storage device 100 is powered on, the processor 112 may load firmware stored in a read only memory (ROM) into a working memory device and perform the overall operation of the storage controller 110. The processor 112 may load the flash translation layer (FTL) 115 into the working memory and program data into or read data from the memory device 120 based on the address translation results of the flash translation layer (FTL) 115.

The command decoder 113 may decode a command parsed from a packet received from the host based on the protocol of the interface negotiated with the host. For example, the command decoder 113 may decode an operation code (opcode) of a command based on a specific protocol to distinguish program commands, erase commands, read commands, and/or secure erase commands. The processor 112 may perform the request from the host based on the decoded commands. In one or more embodiments, the command decoder 113 may be implemented as an independent circuit and/or as a portion of firmware.

The flash translation layer (FTL) 115 may perform various functions such as address mapping, wear-leveling, or garbage collection. In one or more embodiments, the FTL 115 may operate under control of the processor 112. For example, in one or more embodiments, the processor 112 may execute the FTL 115 that has been loaded in the working memory as described above.

The address mapping operation is an operation of converting a logical address, received from the host, into a physical address used to actually program data into the memory device 120 of FIG. 1. For example, a logical block address LBA of user data requested for programming by the host may be converted into a physical address of the memory device 120 of FIG. 1 using the flash translation layer (FTL) 115. In one or more embodiments, a physical address may be a physical page number PPN. In one or more embodiments, the address mapping table managed by the flash translation layer (FTL) 115 may store a mapping relationship between logical page numbers LPN and physical page numbers. In one or more embodiments, each of the logical page numbers LPN may correspond to a plurality of logical block addresses LBAs.

Wear-leveling is a technique for preventing excessive degradation of specific blocks by ensuring that blocks within the memory device 120 of FIG. 1 are uniformly used. For example, wear-leveling may be implemented through a firmware technique for balancing erase counts of physical blocks. Garbage collection is a technique for securing available capacity in the memory device 120 of FIG. 1 by copying valid data from a block to a new block and then erasing the original block.

The SRAM 116 may store temporary data, temporary variables, or the like, for the operation of the processor 112.

The memory interface circuit 117 may provide an interface between the storage controller 110 and the memory device 120. For example, data processed by the processor 112 and/or the packet manager 114 may be written into the memory device 120 through the memory interface circuit 117. For example, data stored in the memory device 120 may be output to the storage controller 110 through the memory interface circuit 117. The storage controller 110 may communicate with the memory device 120 using an additional (e.g., separate) command/address (SCA) protocol through the memory interface circuit 117. For example, the memory interface circuit 117 may communicate with the memory device 120 of FIG. 1 using a first bus for transmitting command/address signals CA and a second bus for transmitting data signals DQ.

The storage controller 110 according to one or more embodiments may transmit a read command to the memory device 120 of FIG. 1, then transmit a first command to the memory device 120 and sense data output from the memory device 120.

The storage controller 110 may not transmit an additional read status command and/or a readout command to the memory device 120 for preparing the output of sensed data. The readout command may be a command instructing the output of data stored in the input/output register. For example, after transmitting a read command along with a specified address to the memory device 120 of FIG. 1, the storage controller 110 may not transmit a read status command to check the sensing status of the data or a command instructing readout. The memory device 120 may perform a portion or all of the functions of the read status command and/or the command instructing readout in response to receiving a single first command. Accordingly, the overhead associated with command and/or address transmission between the storage device 100 and the memory device 120 may be reduced.

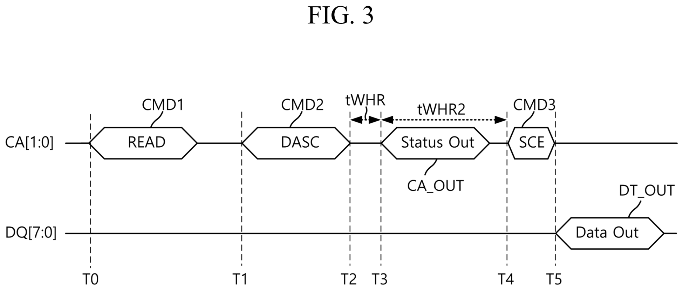

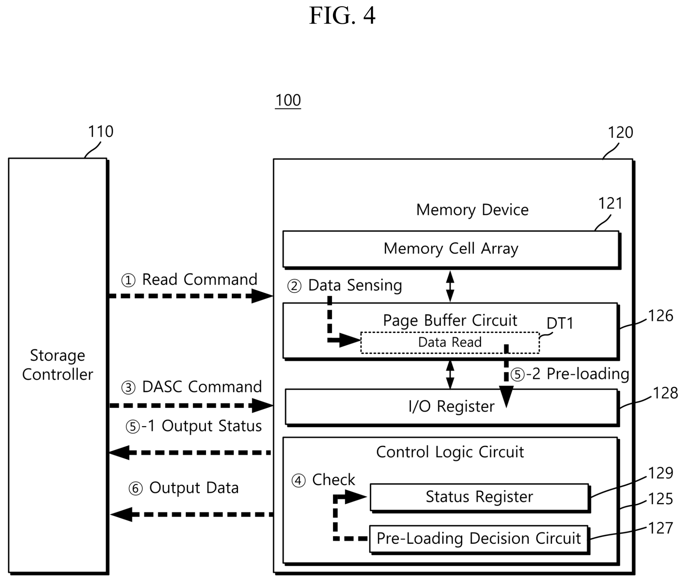

FIG. 3 is a diagram illustrating a first command sequence according to one or more embodiments. FIG. 4 is a block diagram illustrating the operation of the storage device 100 according to one or more embodiments. The sequence of FIG. 3 may be executed by the memory device 120 of FIG. 1.

Referring to FIGS. 3 and 4, the memory device 120 of FIG. 1 may, in response to a read command CMD1 received via a first bus, receive a first command CMD2 via the first bus, output a status of the memory device 120 via the first bus ("CA_OUT") in response to the first command CMD2, and output sensed data via a second bus ("DT_OUT").

The first command sequence and the operation of the storage device 100 are described with reference to FIGS. 1, 3, and 4. FIG. 3 illustrates an example in which the first bus includes 2 bits of command/address signals CA and the second bus includes 8 bits of data signals DQ.

At time T0, the memory device 120 of FIG. 1 may receive a read command CMD1 instructing the reading of stored data from the storage controller 110 (indicated by a circled 1 in FIG. 4). The memory device 120 may receive a specified address, at which the data is stored, along with the read command CMD1. In response to the read command CMD1, the memory device 120 may sense data from the memory cell array 121 at the specified address and store the sensed data (DT1 of FIG. 4) in the page buffer circuit 126 of FIG. 1 (circled 2).

At time T1, the memory device 120 may receive the first command CMD2 from the storage controller 110 (circled 3). For example, the first command of FIG. 3 is illustratively referred to as a DASC command in FIG. 4. In one or more embodiments, the memory device 120 may receive a first address along with the first command CMD2.

At time T2, after the receipt of the first command CMD2 is completed, the memory device 120 may check the status of the memory device 120 within a first time tWHR from time T2 (circled 4). The first time tWHR may be predetermined. For example, the pre-loading decision circuit 127 of the memory device 120 may check the status of the memory device 120 by checking a status register 129 or by receiving the output of the status register 129. In one or more embodiments, when a first address is received along with the first command CMD2, the memory device 120 may check the sensing status of the first data corresponding to the first address. For example, the first address may be a specific column address of the sensed data.

At time T3, the memory device 120 may output a status of the memory device 120 ((circled 5)-1). In one or more embodiments, when a first address is received with the first command CMD2, the memory device 120 may output the sensing status of the first data corresponding to the first address.

The memory device 120 may store the sensed data in the input/output (I/O) register 128 within a second time tWHR2 from time T3, based on the status checked within the first time tWHR from time T2 ((circled 5)-2). For example, when the data sensing is successful, the memory device 120 may store the sensed data in the input/output (I/O) register 128.

In one or more embodiments, the memory device 120 may perform, in parallel, outputting of the status of the memory device 120 or the sensing status of the first data ((circled 5)-1) and storing sensed data in the input/output (I/O) register 128 ((circled 5)-2). For example, at least at one point in time, the output of the status of memory device or the sensing status of the first data ((circled 5)-1) and the storage of sensed data in the input/output (I/O) register 128 ((circled 5)-2) may be performed simultaneously.

At time T4, the memory device 120 may receive a select chip enable signal SCE after a sum of the first time tWHR and the second time tWHR2 from time T2

At time T5, the memory device 120 may output the data stored in the input/output (I/O) register 128 to the second bus DT_OUT in response to the select chip enable signal SCE (circled 6).

Accordingly, the memory device 120 may reduce the overhead for data input/output by performing both status checking and pre-loading of sensed data using a single first command CMD2 for outputting the sensed data.

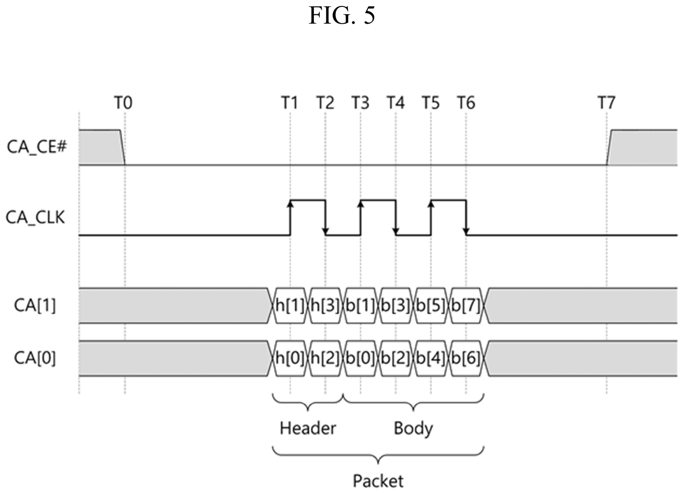

FIG. 5 is a timing diagram illustrating an example of a method of receiving a first command using a separate command/address (SCA) protocol according one or more embodiments.

Referring to FIG. 5, the storage controller 110 may transmit commands and/or addresses to the memory device 120 in the form of packets via a first bus for transmitting command/address signals CA. In the embodiment described with reference to FIG. 5, the first command transmitted via the first bus may include a 4-bit header and an 8-bit body.

At time T0, the storage controller 110 may activate a chip enable signal CA_CE# to a low level to select a chip of the memory device 120 using an additional command/address SCA protocol. The memory device 120 may prepare for data exchange via the first bus in response to the activation of the chip enable signal CA_CE#.

At time T1, the storage controller 110 may sequentially transmit the packet header via the first bus in synchronization with transitions of the command/address clock signal CA_CLK. At time T1, header bits h[0] and h[1] of the first bus may be transmitted to the memory device 120 in synchronization with a rising edge of the command/address clock signal CA_CLK. At time T2, header bits h[2] and h[3] of the first bus may be transmitted to the memory device 120 in synchronization with a falling edge of the command/address clock signal CA_CLK. The header bits h[0], h[1], h[2], and h[3] may be set to '0100,' which indicates the transmission of a command packet, to transmit the first command.

At time T3, the storage controller 110 may sequentially transmit the packet body via the first bus in synchronization with the transitions of the command/address clock signal CA_CLK. At time T3, body bits b[0] and b[1] of the first bus may be transmitted to the memory device 120 in synchronization with the rising edge of the command/address clock signal CA_CLK. At times T4, T5, and T6, the remaining body bits b[2], b[3], b[4], b[5], b[6], and b[7] of the first bus may be transmitted to the memory device 120 two bits at a time in synchronization with either the rising or falling edge of the command/address clock signal CA_CLK. When the packet transmission is complete, the storage controller 110 may deactivate the chip enable signal CA_CE# at time T7.

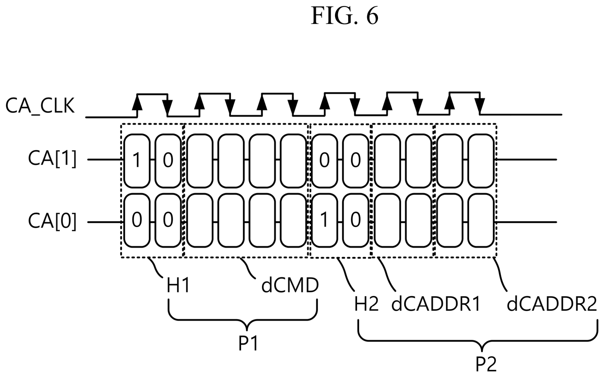

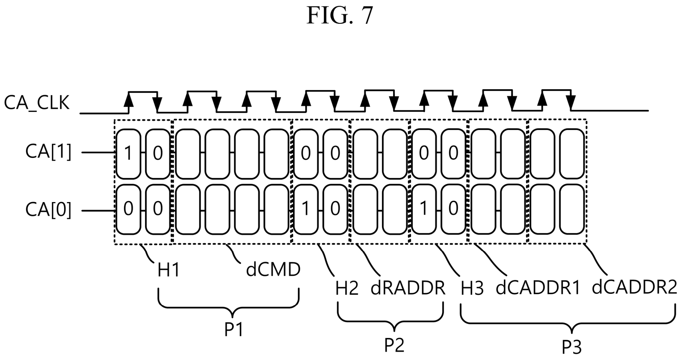

FIGS. 6 and 7 are diagrams illustrating address packets received along with a first command according to one or more embodiments. FIGS. 6 and 7 illustrate an example in which header bits h[0], h[1], h[2], and h[3] indicating a command packet are set to '0100,' and header bits h[0], h[1], h[2], and h[3] indicating an address packet are set to '1000.' According to one or more embodiments, the header bits indicating command packets and address packets may be set to different bit values.

Referring to FIG. 6, a single address packet may be received along with the first command packet of FIG. 5.

In one or more embodiments, the first command packet may include header bits H1 and body bits dCMD, as illustrated in FIG. 5. Following the first packet P1 corresponding to the first command, the memory device 120 may receive a second packet P2 corresponding to a column address.

In one or more embodiments, the second packet P2 may be received during three cycles of the command/address clock signal CA_CLK. For example, the second packet P2 may be captured at each of three rising edges and three falling edges based on the toggle timing of the command/address clock signal.

In one or more embodiments, the second packet P2, an address packet, may include a column address. The address packet may include header bits H2 indicating an address packet and body bits dCADDR1 and dCADDR2 corresponding to the specified column address.

Referring to FIG. 7, in one or more embodiments, two address packets may be received along with the first command packet of FIG. 5.

In one or more embodiments, the first command packet may include header bits H1 and body bits dCMD, as illustrated in FIG. 5. Following the first packet P1 corresponding to the first command, the memory device 120 may receive a second packet P2 corresponding to a row address and a third packet P3 corresponding to a column address.

In one or more embodiments, the second packet P2, an address packet, may include a row address. The address packet may include header bits H2 indicating an address packet and body bits dRADDR corresponding to the specified row address.

In one or more embodiments, the third packet P3, an address packet, may include a column address. The address packet may include header bits H3 indicating an address packet and body bits dCADDR1 and dCADDR2 corresponding to the specified column address.

FIG. 7 illustrates an example in which the storage controller 110 transmits the second packet P2 including the row address before the third packet P3 including the column address. However, in one or more embodiments, the second packet P2 including the row address may be transmitted after the third packet P3 including the column address.

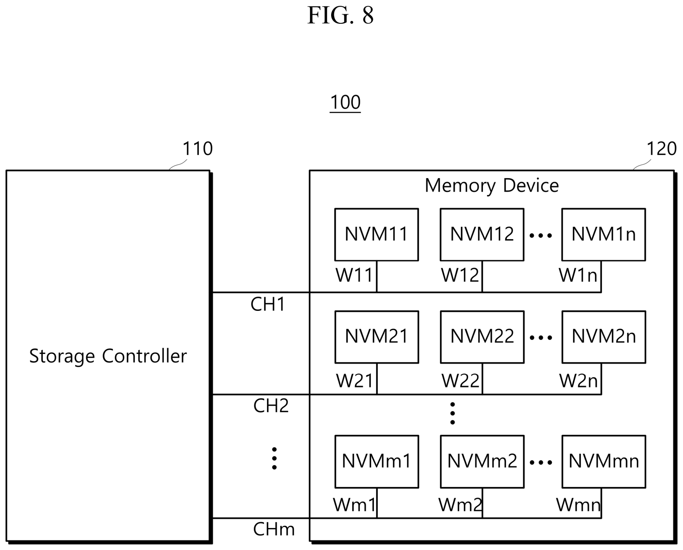

FIG. 8 is a diagram illustrating a configuration of a nonvolatile memory device of a storage device according to one or more embodiments. A storage device 100, a storage controller 110, and a memory device 120 of FIG. 8 may correspond to the storage device 100, the storage controller 110, and the memory device 120 of FIG. 1, respectively.

The storage controller 110 may perform input/output operations on a plurality of memory devices NVM11 to NVMmn through a plurality of channels CH1 to CHm. The memory device 120 and the storage controller 110 may be connected through the plurality of channels CH1 to CHm. In one or more embodiments, the storage controller 110 may include a plurality of controller modules for each channel.

The storage controller 110 may control each of the memory devices NVM11 to NVMmn connected to one of the plurality of channels CH1 to CHm through a way.

The storage controller 110 may transmit and receive signals to and from the memory device 120 through the plurality of channels CH1 to CHm.

The memory device 120 may include the plurality of nonvolatile memory devices NVM11 to NVMmn. Each of the nonvolatile memory devices NVM11 to NVMmn may be a nonvolatile memory package. In one or more embodiments, each of the nonvolatile memory devices NVM11 to NVMmn may include a plurality of dies, but embodiments are not limited thereto.

The memory device 120 according to one or more embodiments may receive a first command for interleaving operations between a plurality of nonvolatile memory devices connected to the same channel.

For example, to read data from each of the nonvolatile memory devices NVM11 to NVM1n connected to the first channel CH1, the storage controller 110 may transmit a first command to each of the nonvolatile memory devices NVM11 to NM1n. The storage controller 110 may transmit a read command to each of the nonvolatile memory devices NVM11 to NVM1n and then transmit a first command to each of the nonvolatile memory devices NVM11 to NVM1n. Each of the nonvolatile memory devices NVM11 to NVM1n may output a status thereof and pre-load sensed data in response to the first command. As the overhead associated with command processing is reduced, each of the nonvolatile memory devices NVM11 to NVM1n may perform read operations in an interleaved manner.

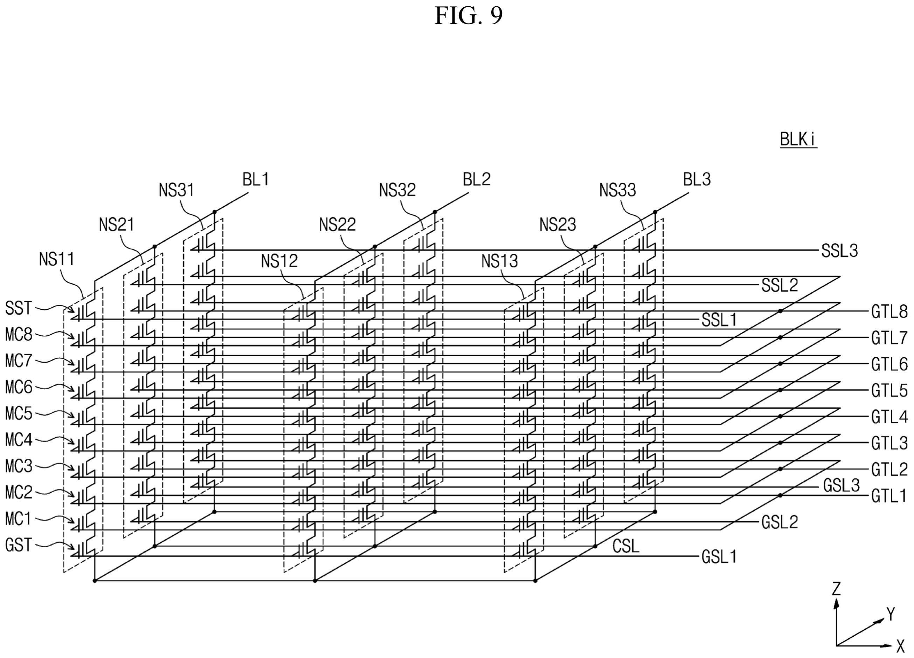

FIG. 9 is a diagram illustrating a configuration of a memory block according to one or more embodiments. A memory block BLKi of FIG. 9 may be one of the memory blocks included in the memory cell array 121 of the memory device 120 of FIG. 1.

When the memory device 120 of the storage device 100 of FIG. 1 is implemented as a 3D V-NAND type flash memory, each of the plurality of memory blocks forming the nonvolatile memory may be represented as an equivalent circuit as illustrated in FIG. 9.

The memory block BLKi illustrated in FIG. 9 represents a three-dimensional memory block formed in a three-dimensional structure on a substrate. For example, a plurality of memory NAND strings included in the memory block BLKi may be formed in a direction perpendicular to the substrate.

Referring to FIG. 9, the memory block BLKi may include a plurality of memory NAND strings NS11 to NS33 connected between bitlines BL1, BL2, and BL3 and a common source line CSL. Each of the plurality of memory NAND strings NS11 to NS33 may include a string select transistor SST, a plurality of memory cells MC1 to MC8, and a ground select transistor GST. In FIG. 9, each of the plurality of memory NAND strings NS11 to NS33 is illustrated as including eight memory cells MC1 to MC8, but embodiments are not limited thereto.

The string select transistor SST may be connected to corresponding string select lines SSL1, SSL2, and SSL3. The plurality of memory cells MC1 to MC8 may be connected to corresponding gate lines GTL1 to GTL8, respectively. The gate lines GTL1 to GTL8 may correspond to wordlines, and a portion of the gate lines GTL1 to GTL8 may correspond to dummy wordlines. The ground select transistor GST may be connected to corresponding ground select lines GSL1, GSL2, and GSL3. The string select transistor SST may be connected to corresponding bitlines BL1, BL2, and BL3, and the ground select transistor GST may be connected to the common source line CSL.

Wordlines at the same height (for example, WL1) may be commonly connected, while both the ground select lines GSL1, GSL2, and GSL3 and string select lines SSL1, SSL2, and SSL3 may be separated. Although FIG. 9 illustrates the memory block BLK connected to eight gate lines GTL1 to GTL8 and three bitlines BL1, BL2, and BL3, embodiments are not limited thereto.

The memory block BLKi may have different bit densities depending on the number of bits stored by the memory cells included in the memory block BLKi.

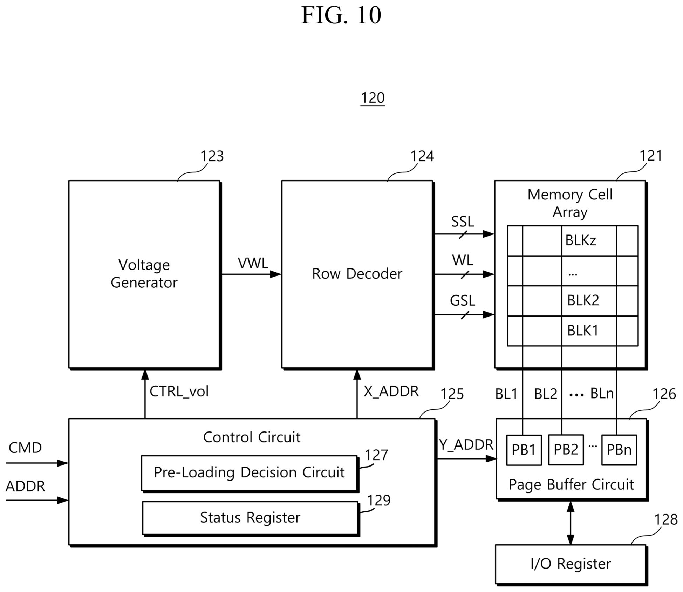

FIG. 10 is a block diagram illustrating a configuration of a memory device according to one or more embodiments. A memory device 120 described with reference to FIG. 10 may correspond to the memory device 120 of FIG. 1 and like reference designators are used for like components.

Referring to FIG. 10, the memory device 120 may include a memory cell array 121, a voltage generator 123, a row decoder 124, the control circuit 125, the page buffer circuit 126, and the input/output (I/O) register 128.

The control circuit 125 may control various operations within the memory device 120. The control circuit 125 may output various control signals in response to a command CMD and/or an address ADDR from the memory interface circuit. For example, the control signals may include a voltage control signal CTRL_vol, a row address X_ADDR, and a column address Y_ADDR.

The memory cell array 121 may include a plurality of memory blocks BLK1 to BLKz (where z is a positive integer), and each of the plurality of memory blocks BLK1 to BLKz may include a plurality of memory cells. The plurality of memory blocks BLK1 to BLKz may be connected to the page buffer circuit 126 through bitlines BL1 to BLn and to the row decoder 124 through wordlines WL, string select lines SSL, and ground select lines GSL.

The page buffer circuit 126 may include a plurality of page buffers PB1 to PBn (where n is an integer of 3 or greater), and each of the plurality of page buffers PB1 to PBn may be connected to memory cells within the plurality of memory blocks BLK1 to BLKz through the plurality of bitlines BL1 to BLn. Each of the plurality of page buffers PB1 to PBn may include a latch. The page buffer circuit 126 may select at least one of the bitlines BL1 to BLn in response to a column address Y_ADDR. The page buffer circuit 126 may operate as a write driver or a sense amplifier depending on an operation mode. For example, a bitline voltage corresponding to the data to be programmed DATA may be applied to the selected bitline during a program operation. The page buffer circuit 126 may sense a current or voltage of the selected bitline to detect data stored in the memory cell during a read operation. The plurality of page buffers PB1 to PBn of the page buffer circuit 126 may sense data stored in memory cells through the plurality of bitlines BL1 to BLn and temporarily store the sensed data.

The voltage generator 123 may generate various types of voltages for performing program, read, and erase operations based on the voltage control signal CTRL_vol.

The row decoder 124 may select one of the plurality of wordlines WL and one of the plurality of string select lines SSL in response to a row address X_ADDR.

The control circuit 125 according to one or more embodiments may include the pre-loading decision circuit 127 and the status register 129.

The pre-loading decision circuit 127 may check status information stored in the status register 129 in response to a first command. The status information may be information that directly or indirectly indicates the success and/or failure of sensing from the memory cell array 121 of the first data specified by a read command received prior to the first command.

The control circuit 125 may set the status register 129 based on the sensing status of the first data. For example, certain bit signals of the status register 129 may be set based on whether the sensing of the data was successful and/or failed. In one or more embodiments, certain bit signals of the status register 129 may be set based on whether the sensed first data contains errors.

The control circuit 125 may output a bit signal of the status register 129 in response to the first command. In one or more embodiments, the control circuit 125 may output a read status command according to the related art.

The pre-loading decision circuit 127 may store the sensed first data in the input/output (I/O) register 128 within a time based on the sensing status of the first data. For example, when the sensing of the first data is successful, the first data may be stored in the input/output (I/O) register 128 within the time.

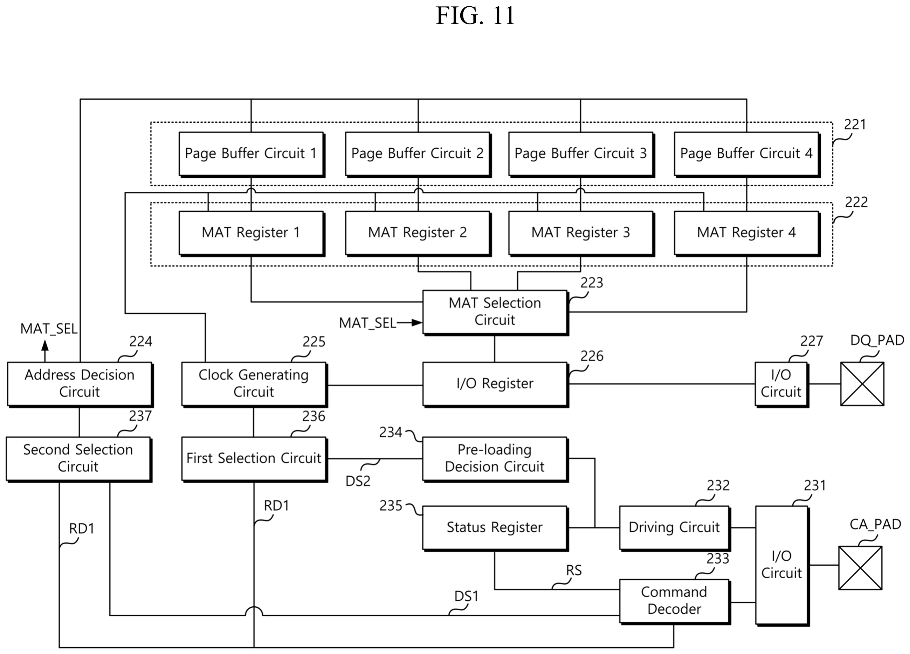

FIG. 11 is a block diagram illustrating a configuration of a memory device according to one or more embodiments, in greater detail. FIG. 11 illustrates components for outputting sensed data from a memory device according to one or more embodiments. In one or more embodiments, the memory device may additionally include various components other than the components illustrated in FIG. 11.

Referring to FIG. 11, a data path of the memory device according to one or more embodiments may include the plurality of page buffer circuits 221, a plurality of mat registers 222 (e.g., second registers), a mat selection circuit 223, an address decision circuit 224, a clock generating circuit 225, an input/output (I/O) register 226 (e.g., first register), an input/output (I/O) circuit 227, and a data pad DQ_PAD. In one or more embodiments, the input/output (I/O) register 226 may correspond to the input/output register 128 of FIG. 1.

Each of the plurality of page buffer circuits 221 may be electrically connected to memory cell arrays of a corresponding mat, and may sense data from the memory cell arrays and temporarily store the sensed data. The plurality of page buffer circuits 221 may receive a clock signal from the clock generating circuit 225.

In one or more embodiments, the address decision circuit 224 may designate a page buffer circuit to sense data from among the plurality of page buffer circuits 221, based on plane information received along with a command. For example, the plane information may be transmitted along with a read command. In one or more embodiments, the plane information may be transmitted along with a logical unit number (LUN) select command.

In one or more embodiments, the address decision circuit 224 may output a mat select signal MAT_SEL. The mat select signal MAT_SEL may include information indicating a mat from which data is to be sensed. The mat select signal MAT_SEL may include information indicating a plane from which data is to be sensed. In one or more embodiments, each mat may include a single plane. For instance, a mat may comprise a set of memory cells arranged on a single plane.

The plurality of mat registers 222 may correspond to the plurality of page buffer circuits 221, respectively. Each of the plurality of mat registers 222 may receive sensed data from a corresponding page buffer circuit.

The mat selection circuit 223 may select one of the plurality of mat registers 222 based on the mat select signal MAT_SEL and transmit the sensed data, received from the selected mat register, to the input/output register 226.

The input/output (I/O) register 226 may transmit the sensed data to the input/output (I/O) circuit 227, and the input/output (I/O) circuit 227 may encode the sensed data and transmit the encoded data to the data pad DQ_PAD electrically connected to a data pin.

In one or more embodiments, a first length, which is the length of an electrical path from the plurality of mat registers 222 to the input/output (I/O) register 226 may be greater than a second length, which is the length of an electrical path from the input/output (I/O) register 226 to the data pin via the data pad DQ_PAD. In one or more embodiments, the first length and the second length may refer to physical lengths of physical paths, for example, on a circuit board. Therefore, when data sensing is successful, the memory device may pre-store the sensed data in the input/output (I/O) register 226 (e.g., the first register) in response to the first command to improve data output efficiency.

Referring to FIG. 11, a control path of a memory device according to one or more embodiments may include a command/address pad CA_PAD, an input/output (I/O) circuit 231, a driving circuit 232, a command decoder 233, a pre-loading decision circuit 234, a status register 235, a first selection circuit 236, and a second selection circuit 237.

The command/address pad CA_PAD may be electrically connected to a command/address pin. The command/address pad CA_PAD may transmit received packets to the command decoder 233 and receive packets encoded by the driving circuit 232.

The command decoder 233 may enable the status register 235 to output status through a path RS when the received packet is a read status command. The command decoder 233 may activate a path RD1 when the received packet is a readout command Dout or RANDOM Dout instructing the output of sensed data. The command decoder 233 may activate a path DS1 when the received packet is a first command according to one or more embodiments.

When the path RD1 is activated by a readout command Dout or RANDOM Dout, the second selection circuit 237 may transmit a row address and a column address, included in the address packet transmitted along with the readout command, to the address decision circuit 224. The address decision circuit 224 may output a mat select signal MAT_SEL based on the row address and column address and select one of the plurality of page buffer circuits 221 to sense data. The first selection circuit 236 may control the clock generating circuit 225, and the clock generating circuit 225 may transmit a clock signal to the mat registers 222.

When path DS1 is activated by the first command according to one or more embodiments, the second selection circuit 237 may transmit the row address and/or the column address, included in the address packet transmitted along with the first command, to the address decision circuit 224. The address decision circuit 224 may output a mat select signal MAT_SEL based on the row address and/or the column address and select one of the plurality of page buffer circuits 221 to sense data.

The pre-loading circuit 234 may receive an output of the status register 235. When the output of the status register 235 indicates successful data sensing, the pre-loading may request the first selection circuit 236 via a path DS2 to control the clock generating circuit 225. The clock generating circuit 225 may transmit a clock signal to the mat registers 222. Among the mat registers 222, a mat register corresponding to the page buffer circuit designated by the address decision circuit 224 may transmit sensed data to the input/output register 226.

The first command according to one or more embodiments may activate paths DS1 and DS2 with a single command. For example, the pre-loading decision circuit 234 may transmit sensed data from the mat register to the input/output register 226 based on the output of the status register 235 without receiving an additional command. As a result, the overhead caused by commands and/or addresses may be reduced compared to the methods using the status read command and the readout command Dout or RANDOM Dout.

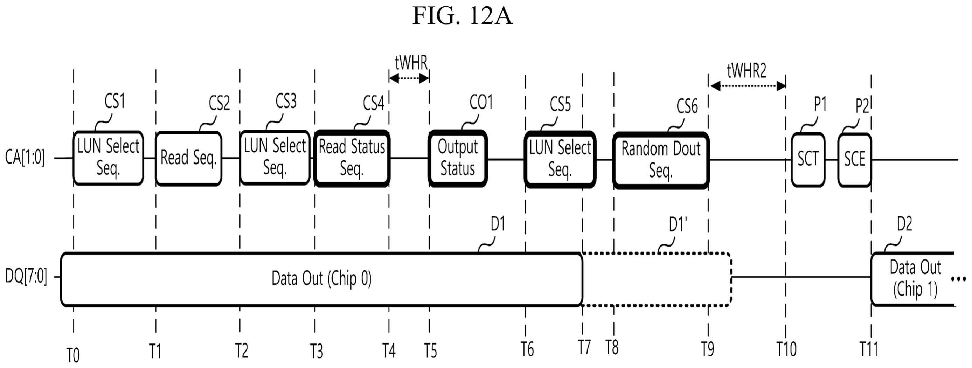

FIG. 12A is a diagram illustrating a chip interleaving operation for reading data, performed by a memory device according to the related art.

Referring to FIG. 12A, a memory device according to the related art may perform a LUN select sequence CS1 for a second chip Chip 1 at time T0 and a read sequence CS2 at time T1 via a first bus transmitting commands/addresses. The memory device may then perform another LUN select sequence CS3 at time T2 and a status read sequence CS4 at time T3. The memory device may check a status of the memory device and/or a data sensing status within a first time tWHR after a status read sequence CS4 and output a status CO1 at time T5. The memory device may perform a LUN select sequence CS5 at time T6, and perform a readout sequence CS6 at time T8. A readout sequence CS6 may be based on a readout command Dout or RANDOM Dout. The memory device may store sensed data in an input/output register within a second time tWHR2 after the readout sequence CS6. The memory device may terminate communication with the first chip Chip 0 in response to a select chip termination signal SCT P1 and start communication with the second chip Chip 1 in response to a select chip enable signal SCE P2.

Referring to FIG. 12A, when data output from the first chip Chip 0 via the second bus for outputting data takes a first time period D1', all sequences performed before time point T9 may be executed in parallel to the data output. However, due to improvements in the data output performance of the memory device, when data output from the first chip Chip 0 via the second bus takes a second time period D1 (that is less than the first time period D1'), specific sequences CS5 and CS6 may be performed after the data output from the first chip Chip 0 via the second bus is completed. The memory device is unable to output data from the second chip Chip 1 until receipt of a select chip termination signal SCT P1 and/or a select chip enable signal SCE P2 for chip interleaving. Accordingly, in spite of improvement in data output performance of the memory device, the performance of chip interleaving may not be improved due to the overhead of commands and/or addresses via the first bus. As a result, data input/output efficiency may not be improved in spite of improvement in data output performance of the memory device.

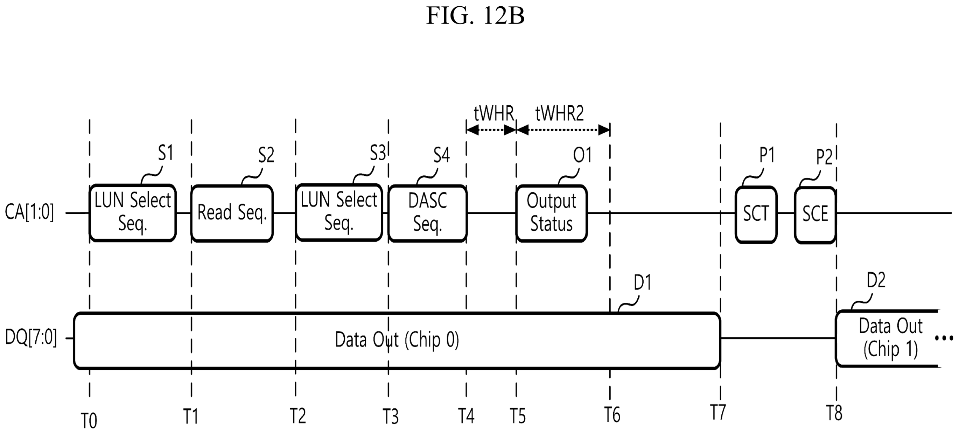

FIG. 12B is a diagram illustrating a chip interleaving operation for data reading, performed by a storage device according to one or more embodiments. The chip interleaving operation of FIG. 12B may be performed by the storage device according to the embodiments described with reference to FIGS. 1 to 11. An example is provided, where the chip interleaving operation of FIG. 12B is performed by the storage device 100 of FIG. 1.

Referring to FIG. 12B, the memory device 120 may perform a LUN select sequence S1 for a second chip Chip 1 at time T0 through a first bus for transmitting commands/addresses. According to one or more embodiments, the LUN select command received in the LUN select sequence S1 may or may not include plane information. When the LUN select command includes plane information, the first command received at time T3 may have the command packet structure of FIG. 6. When the LUN select command does not include plane information, the first command received at time T3 may have the command packet structure of FIG. 7.

At time T1, a read sequence S2 may be executed. At time T2, the memory device may execute another LUN select sequence S3.

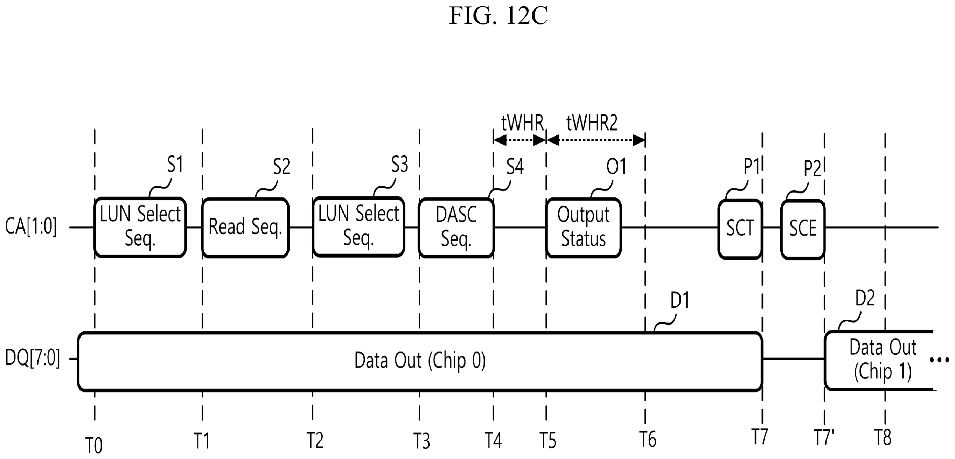

At time T3, a first command sequence S4 according to one or more embodiments may be executed. The first command is referred to as the DASC command in FIGS. 12B and 12C. In response to the first command (i.e., the DASC command), the memory device may check the status of the memory device and/or the data sensing status within a first time tWHR after the first command sequence S4 and output the status O1 at time T5.

The memory device 120 may store sensed data in the input/output register within a second time tWHR2 from time T5. For example, the memory device 120 may store sensed data in the input/output register by time T6. Accordingly, at least a portion of the operation of storing sensed data in the input/output register may be performed in parallel to the status output O1.

After time T6, the memory device 120 may terminate communication with the first chip Chip 0 in response to a select chip termination signal SCT P1 and start communication with the second chip Chip 1 in response to a select chip enable signal SCE P2.

In one or more embodiments, the select chip termination signal SCT P1 and/or the select chip enable signal SCE P2 may be received after the data output from the first chip Chip 0 is completed.

FIG. 12C is a diagram illustrating a chip interleaving operation for data reading in a storage device according to one or more embodiments. According to the embodiment described with reference to FIG. 12C, at least a portion of a select chip termination signal SCT P1 and/or a select chip enable signal SCE P2 may be received in parallel to data output from a first chip Chip 0.

Referring to FIGS. 12B and 12C, compared to the related art, the first command according to one or more embodiments may reduce the overhead of commands and/or addresses through the first bus. For example, the status read sequence CS4 of the related art may be omitted/eliminated. Accordingly, the performance of chip interleaving may be improved, and the efficiency of data input/output may also be improved.

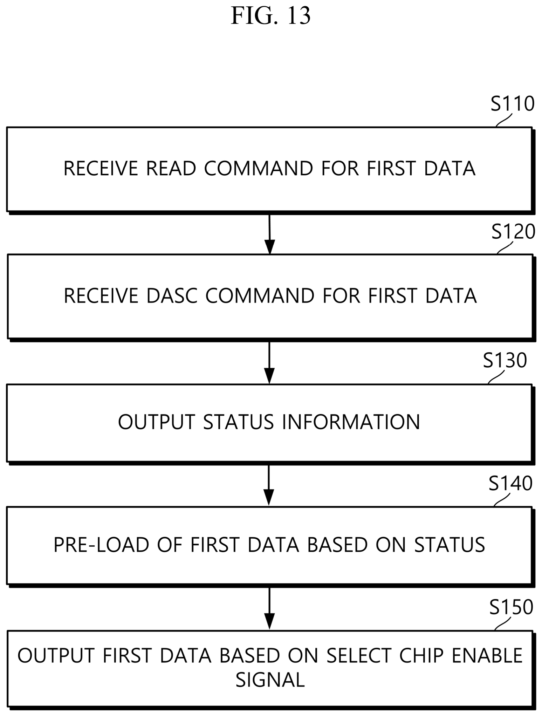

FIG. 13 is a flowchart illustrating the operating a memory device according to one or more embodiments. The operation of FIG. 13 may be performed by the memory device 120 of FIG. 1. The operation of the memory device 120 is described with reference to FIGS. 1 and 13. Detailed descriptions of similar or identical components as illustrated in FIGS. 1-12 are omitted to avoid redundancy.

In operation S110, the memory device 120 may receive a read command instructing the sensing of first data from the storage controller 110. The memory device 120 may receive an address of data to be read along with the read command.

In operation S120, the memory device 120 may receive a DASC command. For example, the memory device 120 may receive the first command described above. The first command is referred to as the DASC command of FIG. 13.

In one or more embodiments, the memory device 120 may receive a column address of the first data along with the first command.

In one or more embodiments, the memory device 120 may receive a row address and a column address of the first data along with the first command.

In one or more embodiments, the memory device 120 may receive a LUN select command before receiving the first command, based on the configuration of the memory device 120. According to one or more embodiments, the memory device 120 may or may not receive plane information corresponding to the first data along with the LUN select command.

In operation S130, the memory device 120 may output status information stored in the status register within a first time (e.g., in a first time period following the receipt of the first command). The status information may include information indicating a status of the memory device. The status information may include information, directly or indirectly indicating the success of sensing the first data.

In operation S140, the memory device 120 may pre-load the first data based on the status information. For example, when the sensing of the first data is successful, the first data may be stored in the input/output (I/O) register 128 of FIG. 1.

In operation S150, the memory device 120 may output the first data based on a select chip enable signal SCE.

As set forth above, according to embodiments, a storage device with improved performance and a method of operating the same may be provided.

According to embodiments, a storage device with improved input/output efficiency and a method of operating the same may be provided.

Embodiments are set out in the following Clauses:
Clause 1. A storage device comprising:
   a nonvolatile memory device comprising an input/output register, the nonvolatile memory device configured to sense data from a memory region corresponding to an address and to transmit the data that is sensed from the memory region; and
   a storage controller configured to transmit a command and the address to the nonvolatile memory device via a first bus and to transmit and receive data to and from the nonvolatile memory device via a second bus,
   wherein:
      the nonvolatile memory device is configured to, in response to a first command that is received from the storage controller, output a sensing status of first data and store the first data in the input/output register.
Clause 2. The storage device of Clause 1, wherein:
   the nonvolatile memory device is configured to, in response to the first command, store the first data in the input/output register based on the sensing status of the first data.
Clause 3. The storage device of Clause 1 or Clause 2, wherein:
   the input/output register is configured to transmit data to an input/output circuit.
Clause 4. The storage device of any preceding Clause, wherein:
   the nonvolatile memory device is configured to, in response to the first command, output the sensing status of the first data via the first bus after a first time has elapsed from a receipt of the first command.
Clause 5. The storage device of Clause 4, wherein:
   the nonvolatile memory device is configured to, in response to the first command, output the first data via the second bus after both the first time and a second time have elapsed from the receipt of the first command.
Clause 6. The storage device of Clause 5, wherein:
   the nonvolatile memory device is configured to output the sensing status of the first data via the first bus within the second time after the first time has elapsed from the receipt of the first command.
Clause 7. The storage device of Clause 5 or Clause 6, wherein:
   the nonvolatile memory device is configured to receive a select chip termination signal or a select chip enable signal via the first bus within the second time after the first time has elapsed from the receipt of the first command.
Clause 8. The storage device of any of Clauses 5-7, wherein:
   the nonvolatile memory device is configured to receive at least a portion of a select chip termination signal or a select chip enable signal via the first bus while outputting the first data through the second bus.
Clause 9. The storage device of any preceding Clause, wherein:
   the nonvolatile memory device comprises:
   a first register configured to receive sensed data that is stored in a single page buffer circuit, among a plurality of page buffer circuits, and to output the sensed data via the first bus;
   a status register configured to store a status of the nonvolatile memory device; and
   a pre-loading decision circuit configured to control transmission of the first data, stored in the single page buffer circuit, to the first register based on the sensing status of the first data from the status register.
Clause 10. The storage device of Clause 9, wherein:
   the nonvolatile memory device further comprises:
   a plurality of mats, each comprising memory cells;
   the plurality of page buffer circuits, respectively corresponding to the plurality of mats;
   a plurality of second registers, respectively corresponding to the plurality of page buffer circuits, and configured to receive the sensed data from a corresponding one of the plurality of page buffer circuits;
   the first register electrically connected to each of the plurality of second registers and configured to receive the sensed data from one of the plurality of second registers; and
   at least one first pin through which the first bus is formed;

   a first distance between the first register and each of the plurality of second registers is greater than a second distance between the first register and the at least one first pin; and
   the pre-loading decision circuit is configured to control transmission of the first data from a second register of the plurality of second registers to the first register.
Clause 11. The storage device of any preceding Clause, wherein:
   the nonvolatile memory device is configured to receive the first command through the first bus during a first time period and to receive a first column address through the first bus during a second time period following the first time period.
Clause 12. The storage device of Clause 11, wherein:
   the nonvolatile memory device is configured to, in response to the first command, output the sensing status of the first data corresponding to the first column address and to store the first data corresponding to the first column address in the input/output register.
Clause 13. The storage device of Clause 11 or Clause 12, wherein:
   the nonvolatile memory device is configured to receive the first column address over two cycles based on a toggle timing of a command/address clock signal received from the storage controller.
Clause 14. The storage device of any of Clauses 11-13, wherein:
   the nonvolatile memory device is configured to receive a second command for designating a logical unit number (LUN) via the first bus during a third time period and to receive a plane number via the first bus during a fourth time period following the third time period; and
   the third time period and the fourth time period are prior to the first time period.
Clause 15. The storage device of any of Clauses 11-14, wherein:
   the nonvolatile memory device is configured to receive a first row address via the first bus during a third time period following the second time period.

While various embodiments have been shown and described above with reference to the drawings, it will be apparent to those skilled in the art that modifications and variations could be made without departing from the scope of the present disclosure as defined by the appended claims.

## Claims

1. A storage device comprising:
a nonvolatile memory device (120) comprising an input/output register (128), the nonvolatile memory device (120) being configured to sense data from a memory region corresponding to an address and to transmit the data that is sensed from the memory region; and
a storage controller (110) configured to transmit a command and the address to the nonvolatile memory device (120) via a first bus (130) and to transmit and receive data to and from the nonvolatile memory device (120) via a second bus (140),
wherein:
the nonvolatile memory device (120) is configured to, in response to a first command that is received from the storage controller (110), output a sensing status of first data and store the first data in the input/output register (128).

2. The storage device of claim 1, wherein:
the nonvolatile memory device (120) is configured to, in response to the first command, store the first data in the input/output register (128) based on the sensing status of the first data.

3. The storage device of claim 1 or claim 2, wherein:
the nonvolatile memory device (120) is configured to, in response to the first command, output the sensing status of the first data via the first bus (130) after a first time has elapsed from a receipt of the first command.

4. The storage device of claim 3, wherein:
the nonvolatile memory device (120) is configured to, in response to the first command, output the first data via the second bus (140) after both the first time and a second time have elapsed from the receipt of the first command.

5. The storage device of claim 4, wherein:
the nonvolatile memory device is configured to output the sensing status of the first data via the first bus (130) within the second time after the first time has elapsed from the receipt of the first command.

6. The storage device of claim 4 or claim 5, wherein:
the nonvolatile memory device (120) is configured to receive a select chip termination signal or a select chip enable signal via the first bus (130) within the second time after the first time has elapsed from the receipt of the first command.

7. The storage device of any of claims 4-6, wherein:
the nonvolatile memory device (120) is configured to receive at least a portion of a select chip termination signal or a select chip enable signal via the first bus (130) while outputting the first data through the second bus (140).

8. The storage device of any preceding claim, wherein:
the nonvolatile memory device (120) comprises:
a first register (226) configured to receive sensed data that is stored in a single page buffer circuit, among a plurality of page buffer circuits (221), and to output the sensed data via the first bus (130);
a status register (235) configured to store a status of the nonvolatile memory device (120); and
a pre-loading decision circuit (234) configured to control transmission of the first data, stored in the single page buffer circuit, to the first register (226) based on the sensing status of the first data from the status register (235).

9. The storage device of any preceding claim, wherein:
the nonvolatile memory device (120) is configured to receive the first command through the first bus (130) during a first time period and to receive a first column address through the first bus (130) during a second time period following the first time period.

10. The storage device of claim 9, wherein:
the nonvolatile memory device (120) is configured to, in response to the first command, output the sensing status of the first data corresponding to the first column address and to store the first data corresponding to the first column address in the input/output register (128).

11. A nonvolatile memory device configured to receive a command and an address via a first bus (130) and transmit and receive data to and from an external device (110) that is external to the nonvolatile memory device via a second bus (140), the nonvolatile memory device comprising:
a memory cell array (121) configured to store data;
a page buffer circuit (126) configured to sense data from the memory cell array (121);
an input/output register (128) electrically connected to a data input/output pin (DQ_PIN); and
a control circuit (125) configured to, in response to a first command that is received from the external device (110), output a sensing status of first data and store the first data in the input/output register (128).

12. The nonvolatile memory device of claim 11, wherein:
the control circuit (125) is configured to, in response to the first command, store the first data in the input/output register (128) based on the sensing status of the first data.

13. The nonvolatile memory device of claim 11 or claim 12, wherein:
the control circuit (125) is configured to, in response to the first command, output the sensing status of the first data via the first bus (130) after a first time has elapsed from a receipt of the first command, and output the first data via the second bus (140) after the first time and a second time have elapsed from the receipt of the first command.

14. The nonvolatile memory device of any of claims 11-13, wherein:
the control circuit (125) is configured to, in response to the first command, output status information of a status register in parallel with storing of the first data in the input/output register (128).

15. A method of operating a nonvolatile memory device, the method comprising:
receiving a read command via a first bus (S110), the read command being for reading first data from an external device that is external to the nonvolatile memory device;
receiving a first command via the first bus (S120), the first command being related to the first data;
in response to the first command, outputting status information of a status register via the first bus (S130);
in response to the first command, storing the first data in an input/output register based on the status information (S140); and
in response to a select chip enable signal, outputting the first data stored in the input/output register via a second bus (S150).
